# EUROPÄISCHE PATENTSCHRIFT

(11) **EP 2 856 478 B1**
(45) Veröffentlichungstag und Bekanntmachung des Hinweises auf die Patenterteilung: **06.07.2016**
(21) Anmeldenummer: 13725335.7
(22) Anmeldetag: 22.05.2013
(51) Int. Cl.: H01G 4/232, H01L 41/293

(54) **VERFAHREN ZUM HERSTELLEN EINES VIELSCHICHTBAUELEMENTS**
METHOD FOR PRODUCING A MULTILAYER COMPONENT
PROCÉDÉ DE FABRICATION D'UN COMPOSANT MULTICOUCHE

(30) Priorität: 04.06.2012 DE 102012104830
(43) Veröffentlichungstag der Anmeldung: 08.04.2015
(73) Patentinhaber: Epcos AG, 81669 München (DE)
(72) Erfinder: RINNER, Franz, A-8530 Deutschlandsberg (AT); SOMITSCH, Dieter, A-8522 Groß St. Florian (AT)
(74) Vertreter: Epping - Hermann - Fischer
(86) Internationale Anmeldenummer: PCT/EP2013/060523
(87) Internationale Veröffentlichungsnummer: WO 2013/182424

(56) Entgegenhaltungen:
- EP-A1- 1 835 553
- JP-A- 2005 072 370
- US-A- 5 568 679
- US-A1- 2006 067 029

## Beschreibung

Die Erfindung betrifft ein vollaktives Vielschichtbauelement, ein Verfahren zum Herstellen eines vollaktiven Stapels und ein Verfahren zum Herstellen eines vollaktiven Vielschichtbauelements aus dem vollaktiven Stapel.

Vielschichtbauelemente umfassen unter anderem Kondensatoren und Piezoaktoren, die jeweils alternierende dielektrische Schichten und Innenelektroden enthalten. Im Falle der Piezoaktoren sind die dielektrischen Schichten zudem piezoelektrisch. Daher gehören Piezoaktoren zu den Piezoelementen.

Piezoelemente werden unter anderem für Positionierelemente, Ultraschallwandler, Sensoren und in Tintenstrahldruckern sowie in der Automobiltechnik zum Ansteuern von Kraftstoffeinspritzvorrichtungen verwendet. Die Wirkungsweise eines Piezoelements beruht auf der Deformation piezokeramischer Materialien, wie z. B. Blei-Zirkonat-Titanat, unter Einwirkung eines elektrischen Feldes. Wird an das Piezoelement eine elektrische Spannung angelegt, so dehnt sich dieses in senkrechter Richtung zum erzeugten elektrischen Feld aus (inverser Piezo-Effekt).

Vorteile von Piezoelementen sind unter anderem deren relativ große Geschwindigkeit, deren relativ große Effektivität und, wenn als Piezoaktor verwendet, deren relativ kleiner Stellweg.

Soll jedoch mit dem Piezoaktor ein relativ großer Stellweg erreicht werden, dann wird für den Piezoaktor ein Piezostapel aus mehreren, abwechselnd aufeinander folgenden piezoelektrischen Schichten und Innenelektrodenschichten verwendet, wie dies z. B. in der JP 03174783 A offenbart ist.

Der in der JP 03174783 A offenbarte Piezoaktor ist derart ausgeführt, dass die Innenelektrodenschichten abwechselnd mit an gegenüber liegenden Außenflächen des Piezostapels angeordneten Außenelektroden elektrisch verbunden sind. Die Innenelektrodenschichten, die mit einer der beiden Außenelektroden elektrisch verbunden sind, sind daher bis zu der Außenseite, an der diese Außenelektrode angeordnet ist, für die elektrische Verbindung mit der Außenelektrode herangeführt. Damit die Innenelektrodenschichten jedoch von der anderen Außenelektrode elektrisch isoliert sind, reichen die Innenelektrodenschichten nicht bis zur Außenseite des Piezostapels heran, an der die weitere Außenelektrode angeordnet ist. In diesen Bereichen sind die Innenelektrodenschichten von der Außenseite zurückgesetzt. Dies wird erreicht, indem der Piezostapel in diesen Bereichen mit Silikonharz gefüllten Schlitzen versehen ist.

Durch die zurückgesetzten Innenelektrodenschichten ergeben sich in diesen Bereichen zugeordneten piezoelektrischen Schichten so genannte inaktive Zonen. Üblicherweise werden die inaktiven Zonen bei der schichtweisen Herstellung des Piezostapels erzeugt. Durch Toleranzen der Prozesse, Stapeln, Trennen, Entbindern und Schleifen während der Herstellung des Piezostapels mit inaktiven Zonen und aufgrund der Vorgabe einer zuverlässigen elektrischen Isolierung der Innenelektrodenschichten zur entsprechenden Außenelektrode ergeben sich relativ große inaktive Zonen von typischerweise 10 Prozent des Piezostapelquerschnitts. Die inaktiven Zonen, werden bei einer an den Außenelektroden- beziehungsweise Innenelektrodenschichten angelegten elektrischen Spannung von einer reduzierten elektrischen Feldstärke durchsetzt und dehnen sich daher bei angelegter elektrischer Spannung weniger stark als die übrigen so genannten aktiven Zonen der piezoelektrischen Schichten. Dies führt zu mechanischen Spannungen insbesondere in den inaktiven Zonen und den Randbereichen zu den inaktiven Zonen und kann zu so genannten Polungsrissen in den inaktiven und aktiven Zonen der piezoelektrischen Schichten, sowie in den Außenelektroden führen. Die Gefahr von Polungsrissen ist umso größer, je größer die inaktiven Zonen sind.

EP 1835553 A1 und US 5,568,679 A offenbaren jeweils einen piezoelektrischen Aktor als Vielschichtbauelement, worin eine eingebrannte Schicht die gegenpoligen inneren Elektroden von der äußeren Elektrode isoliert. In US 5,568,679 A wird zudem ein Verfahren unter Verwendung von Elektrophorese unterVerwendung von Elektrophorese offenbart, welches die gegenpoligeninneren Elektroden gegen die äußere Elektrode isoliert, indem eine Schicht aufgetragen wird.

JP 2005-072370 A und US 2006/067029 A1 offenbaren jeweils alternative Verfahren unter Verwendung von anodischer Oxidation bzw. elektrischer Abscheidung.

Die Aufgabe der Erfindung ist, ein Verfahren zur Herstellung eines Vielschichtbauelement anzugeben, bei dem die Leistung im Betrieb verbessert ist. Insbesondere, bei dem die mechanischen Spannungen in der Piezokeramik im Betrieb des Piezoaktors wesentlich verringert sind.

Die Aufgabe der Erfindung wird gelöst durch ein Verfahren zur Herstellung eines vollaktiven Stapels bzw. -riegels oder dessen grünen Vorläufers, umfassend:
- Bereitstellen eines gesinterten oder ungesinterten Stapels mit den jeweils in Stapelrichtung verlaufenden Seiten A, B, C und D aus mehreren abwechselnd aufeinanderfolgenden keramischen dielektrischen Schichten und Innenelektrodenschichten, wobei die Innenelektrodenschichten bezüglich der Seiten A und C jeweils durchgehend ausgebildet sind und bezüglich entweder der Seite B oder der Seite D jeweils nicht durchgehend ausgebildet sind, so dass ein Teil der Innenelektroden oder deren ungesinterte Vorläufer die Seite B, nicht aber die Seite D, kontaktiert und ein anderer Teil der Innenelektroden oder deren ungesinterte Vorläufer die Seite D, nicht aber die Seite B, kontaktiert;
- Zusammenfassen und temporäres Kontaktieren der die jeweilige Seite kontaktierenden Innenelektroden oder deren ungesinterte Vorläufer auf einer der Seiten B oder D über einen Außenkontakt, so dass die die jeweilige Seite kontaktierenden Innenelektroden selektiv elektrisch angesteuert werden können;
- Elektrisches Ansteuern der über die Seite B ansteuerbaren Innenelektroden und Beschichten mindestens der elektrisch angesteuerten Innenelektroden oder deren ungesinterte Vorläufer auf der Seite A mit Lack und Aushärten, Aufschmelzen und gegebenenfalls Entwickeln des Lacks, so dass nach dem Entwickeln oder Aufschmelzen die über die Seite B elektrisch ansteuerbaren Innenelektroden auf der Seite A mit Lack bedeckt sind;
- Elektrisches Ansteuern der über die Seite D ansteuerbaren Innenelektroden und Beschichten mindestens der elektrisch angesteuerten Innenelektroden oder deren ungesinterte Vorläufer auf der Seite C mit Lack und Aushärten, Aufschmelzen und gegebenenfalls Entwickeln des Lacks, so dass nach dem Entwickeln oder Aufschmelzen die über die Seite D elektrisch ansteuerbaren Innenelektroden auf der Seite C mit Lack bedeckt sind;
- Aufbringen einer Einbrennpaste auf die Seiten A und C, sowie Entbindern und Brennen der Einbrennpaste, wobei der Lack entfernt wird;
- Vereinzeln des Stapels zu mindestens einem vollaktiven Stapel mit den Seiten A', B', C' und D' oder dessen grünem Vorläufer mit den beschichteten Innenelektroden oder deren ungesinterte Vorläufer auf den Seiten A' und C'. Soll mit dem Verfahren ein vollaktiver Piezostapel erzeugt werde, werden für die keramischen dielektrischen Schichten keramische piezolektrische Schichten eingesetzt. Vorzugsweise umfasst der (Ausgangs)stapel Bereiche, worin die Innenelektrodenschichten die Seiten B und D jeweils abwechselnd kontaktieren. Insbesondere bevorzugt kontaktieren im (Ausgangs)stapel alle Innenelektrodenschichten die Seiten B und D jeweils abwechselnd. Unter einem vollaktiven Stapel ist erfindungsgemäß ein Stapel zu verstehen, bei dem die Innenelektroden durchgehend sind, d.h. sich über die gesamte Querschnittsfläche des Stapels erstrecken. Durch diese Ausgestaltung reichen die gesamten Innenelektroden bis an die Außenseite des Stapels, weshalb dieser keine inaktiven Zonen aufweist. Dadurch wird die Leistung des Vielschichtbauelements um Betrieb verbessert und im Fall des Piezoaktors die Höhe der mechanischen Spannungen in der Piezokeramik während des Betriebs verringert.

Der in dem Verfahren zur Herstellung eines vollaktiven Stapels bereitgestellte (Ausgangs)stapel wird beispielsweise durch alternierendes Stapeln von mindestens zwei Teilstapeln hergestellt, wobei jeder der Teilstapel eine dielektrische Schicht und eine darauf angeordnete Innenelektrodenschicht aufweist. Der bereitgestellte Stapel wird dabei insbesondere hergestellt, indem sogenannte grüne Keramikfolien beispielsweise im Siebdruckverfahren mit metallischen Pasten bedruckt werden. Das Bedrucken wird dabei so ausgeführt, dass die metallischen Pasten die keramische Grünfolie vollständig bedecken, wobei auf einer Seite ein unbedruckter Rand belassen wird. Die metallischen Pasten weisen z.B. AgPd- oder Cu-Partikel, Lösungsmittel und weitere Zusätze auf. Danach werden typischerweise ca. 300 bis 600 mit der Paste versehene grüne Keramikfolien aus den beiden Teilstapeln so übereinandergelegt, dass ein Block entsteht, in dem die metallischen Zwischenschichten zwei gegenüberliegende Seiten abwechselnd kontaktieren und jede zweite Zwischenschicht bezüglich des unbedruckten Randes identisch ausgerichtet ist. Der entstandene Stapel wird dann durch Pressen zu einem sogenannten Grünblock verarbeitet. Anschließend wird der Grünblock zur Entfernung von organischen Bestandteilen (insbesondere Bindemittel) entbindert und gegebenenfalls gesintert. Aus einem Grünblock können durch Trennung in einzelne Stapel gegebenenfalls mehrere (Ausgangs)stapel bzw. -riegel erzeugt werden.

Die keramischen dielektrischen Schichten können ein piezoelektrisches Material, z.B. Bleizirkonattitanat (PZT), umfassen.

In dem Verfahren zur Herstellung eines vollaktiven Stapels oder dessen grünen Vorläufers kann der in dem ersten Schritt bereitgestellte (Ausgangs)stapel entweder gesintert oder grün sein.

Vorzugsweise wird als Lack ein Fotolack und/oder ein Pulverlack und/oder ein stromstrukturierbarer Funktionslack (nachfolgend kurz als "Funktionslack" bezeichnet) verwendet.

Fotolacke (Englisch: "photoresist") sind dem Fachmann aus der fotolithografischen Strukturierung bekannt. Sie werden insbesondere in der Mikroelektronik und der Mikrosystemtechnik für die Produktion von Strukturen im Mikro- und Submikrometerbereich sowie bei der Leiterplattenherstellung verwendet. Die wichtigsten Ausgangsstoffe für Fotolacke sind Polymere (z. B. Polymethylmethacrylat, Polymethylglutarimid) bzw. Epoxidharze (z. B. SU-8), Lösungsmittel wie Cyclopentanon oder Gamma-Butyrolacton, sowie eine fotoempfindliche Komponente. Es sind Negativlacke und Positivlacke bekannt. Der Negativlack polymerisiert durch Belichtung und/oder Aushärten, das heißt, nach der Entwicklung (Entfernung der nicht-polymerisierten Bereiche durch Lösungsmittel) bleiben die belichteten und/oder ausgehärteten Bereiche stehen. Bei Positivlacken wird der bereits verfestigte Lack durch Belichtung wieder löslich für entsprechende Entwicklerlösungen, das heißt, nach der Entwicklung bleiben nur die Bereiche übrig, welche durch eine Maske vor der Bestrahlung geschützt sind und somit nicht belichtet werden. Erfindungsgemäß können sowohl Positiv- als auch Negativlacke verwendet werden.

Pulverlacke sind organische, meist duroplastische Beschichtungspulver mit einem Festkörperanteil von 100 %. Das Beschichten mit Pulverlacken erfordert im Gegensatz zu allen anderen Beschichtungstechnologien keine Lösemittel. Zur Produktion der Pulverlacke werden Verarbeitungsverfahren wie die Extrusion und das Vermahlen eingesetzt. Pulverlacke bestehen aus Bindemitteln, Additiven, Farbmitteln und Füllstoffen. Charakteristisch für Pulverlacke ist das Fehlen von Lösemitteln. Die chemischen Unterschiede zwischen den in Pulverlacken und konventionellen Lacken eingesetzten Rohstoffen sind nicht groß. Die Vernetzungsmechanismen des Pulverlackfilmes ähneln denen eines Einbrennlackes, bei dem unter Temperatureinfluss zwei Reaktionspartner durch Bildung eines organischen Netzwerkes eine chemische Verbindung eingehen.

Unter der Bezeichnung Funktionslacke werden erfindungsgemäß Lacke verstanden, deren Vernetzung und Aushärtung über eine vorangehende lokale elektrische Ansteuerung (Durchfluss von elektrischen Strom) erfolgt. Diese Funktionslacke sind aus der Gruppe ausgewählt, die aus Lacken wie sie in der Elektronenstrahllithografie verwendet werden (z. B. PMMA), Lacke mit durch Bestromung bewirkter thermischer Aushärtung, indirekt über Strom vernetzende Lacke (z. B. Mischungen aus elektrolumineszierenden Polymers mit photoempfindlichen Substanzen) und deren Mischungen besteht. In einer erfindungsgemäßen Ausführungsform umfassen die Funktionslacke Lacke wie sie in der Elektronenstrahllithografie verwendet werden (z.B. PMMA). Diese werden auch als Elektronenstrahlresists bezeichnet. Der Mechanismus der "Belichtung" von Elektronenstrahlresists mit energiereichen Elektronen wird in der Elektronenstrahllithografie zur Strukturierung verwendet. In Analogie zum Fotolack erfolgt die chemische Veränderung durch den lokalen Elektronenstrom. Um die für die " Belichtung" des Lackes (Bestromung des Lackes) mit Elektronen erforderliche kinetischer Energie der Elektronen zu generieren besitzt der Lack vorzugsweise eine hohe Bestrahlungsempfindlichkeit sowie eine Leitfähigkeit, die ausreichend groß ist, dass Ladungen transportiert werden können und eine elektrostatische Aufladung des Lackes vermieden wird. Die elektrische Ansteuerung erfolgt vorzugsweise über gepulste Hochspannung. In einer erfingungsgemäß besonders bevorzugten Ausführungsform wird auf der Seite der Kathode (Elektronenemitter) ein wenige µm großer Spalt zum Lack aufrechterhalten. Die über Feldemission aus der Kathode austretenden Elektronen werden über diesen Spalt beschleunigt und treffen dann mit höherer Energie auf den Lack. Der Spalt Kathode / Lack kann entweder auf der von der dielektrischen Schicht abgewandten Seite der Lackoberfläche zur äußeren Elektrode als auch zwischen (zurückgezogenen) Innenelektroden und appliziertem Lack realisiert werden.

In einer weiteren erfindungsgemäßen Ausführungsform umfassen die Funktionslacke Lacke, die auf thermischer Aushärtung durch Bestromung beruhen. Bei diesen Funktionslacken wird die kinetische Energie der Elektronen in thermische Energie übergeführt, die eine lokale Aushärtung des Lackes bewirkt. Der Lack besitzt hierzu eine geeignete Leitfähigkeit, die groß genug ist, um eine elektrostatische Aufladung des Lackes bei der Bestromung zu verhindern. Um den Effekt der thermischen Aushärtung lokal auf den Bereich der angesteuerten Elektroden zu begrenzen, wird vorzugsweise der Wärmeleitung entgegengewirkt, d.h. die Ansteuerung erfolgt vorzugsweise über kurze Hochspannungspulse.

In einer weiteren erfindungsgemäßen Ausführungsform umfassen die Funktionslacke Lacke, die indirekt über Strom vernetzt werden können. Diese Funktionslacke umfassen beispielsweise eine Kombination eines elektrolumineszierenden Lack (enthaltend ein elektrolumineszierendes Polymer) mit einem Fototack (enthaltend photoempfindliche Komponenten). Bei Verwendung geeigneter metallischer Kontakte wird ein Wirkungsmechanismus wie bei einer OLED (organischen Lechtdiode) hergestellt. In dieser Konfiguration übernimmt das stromdurchflossene elektroluminiszierende Polymer, das in dem elektrolumineszierenden Lack enthalten ist, die Funktion der lokalen Belichtung des Fotolacks, der die photoempfindlichen Komponenten enthält.

Die vorstehenden Funktionslacke können als Positiv- oder Negativlacke ausgeführt sein. Bei Negativlacken bleiben nach dem Aushärten und Entwickeln (Entfernen der nicht polymerisierten Bereiche des Lacks durch Lösungsmittel) die Bereiche über den elektrisch angesteuerten Innenelektroden stehen, während die übrigen Bereiche bei der Entwicklung herausgelöst werden. Bei Verwendung eines Positivlacks ist dies umgekehrt.

Als Einbrennpaste kann beispielsweise eine Glaspaste verwendet werden. Beim Entbindern wird dann auch der Binder der Glaspaste entfernt. Die Dicke des eingebrannten Glases beträgt vorzugsweise 20 µm bis 80 µm.

In einer erfindungsgemäßen Ausführungsform wird zum Belichten bzw. Aushärten des stromstrukturierbaren Funktionslackes eine Gegenelektrode auf den Funktionslack positioniert und eine Spannung, vorzugsweise gepulste Hochspannung angelegt. Die Vernetzung bzw. Aushärtung erfolgt durch die mit dem Strom verbundene Wärmeentwicklung bzw. chemische Veränderung (wie oben beschrieben) des Lackes. Als Funktionslack kann beispielsweise ein PMMA (Polymethylmethacrylat) basierender Dickschichtlack (typischerweise 50µm dick) verwendet werden. Der stromhärtende Funktionslack kann mit weiteren Komponenten vermischt werden, um einen definierten Widerstand einzustellen. Wird als Funktionslack ein sogenannter Negativlack verwendet, bleiben nach dem Aushärten und Entwickeln (Entfernen der nicht -polymerisierten Bereich des Funktionslacks durch Lösungsmittel) die Bereiche des Funktionslacks über den elektrisch angesteuerten Innenelektroden stehen, während die übrigen Bereiche bei der Entwicklung herausgelöst werden. Bei Verwendung eines Positivlacks ist dies umgekehrt.

In einer erfindungsgemäßen Ausführungsform wird statt Funktionslack Pulverlack verwendet. Der Pulverlack wird hierzu elektrostatisch auf die elektrisch angesteuerten Innenelektroden aufgetragen und aufgeschmolzen.

In einer erfindungsgemäßen Ausführungsform wird der Pulverlack zusätzlich zum Fotolack verwendet. Hierzu wird der Pulverlack elektrostatisch auf eine Schicht aus Fotolack aufgetragen, wobei der Pulverlack von den elektrisch angesteuerten Innenelektroden angezogen wird. Der aufgeschmolzene Pulverlack kann dann als Maske verwendet und der Fotolack normal belichtet werden. Wird als Fotolack ein Negativlack verwendet, bleiben nach dem Aushärten und Entwickeln (Entfernen der nicht-polymerisierten Bereiche des Fotolacks durch Lösungsmittel) die Bereiche des Fotolacks über den nicht-elektrisch angesteuerten Innenelektroden stehen, während die übrigen Bereiche bei der Entwicklung herausgelöst werden. Bei Verwendung eines Positivlacks ist dies umgekehrt.

In einer erfindungsgemäßen besonderen Ausführungsform sind die Fotolacke bzw. die stromhärtenden Funktionslacke mit einem Glasanteil ausgestattet. Dadurch erhält man eine mit Licht oder Strom strukturierbare Glaspaste die zur direkten Isolierung der über die Außenkontakte auf den Seiten B und D angesteuerten Elektroden verwendet werden kann.

In einem weiteren Aspekt der Erfindung wird ein Verfahren zur Herstellung eines vollaktiven Vielschichtelements zur Verfügung gestellt. Das Verfahren umfasst im Einzelnen das Herstellen eines vollaktiven Stapels, wie vorstehend beschrieben, und gegebenenfalls Sintern des vollaktiven Stapels oder dessen grünen Vorläufers; und Aufbringen von Außenelektroden auf den Seiten A' und C' des vollaktiven Stapels und Kontaktieren der unbeschichteten Innenelektroden, so dass die beiden Außenelektroden mit den unbeschichteten Innenelektrodenschichten elektrisch verbunden sind.

In einem Referenzbeispiel wird ein vollaktives Vielschichtelement zur Verfügung gestellt. Im Einzelnen umfasst das vollaktive Vielschichtelement einen vollaktiven Stapel aus mehreren dielektrischen Schichten und Innenelektrodenschichten und zwei auf gegenüberliegenden Seiten des Stapels angeordneten Außenelektroden, wobei mindestens ein Teil der Innenelektrodenschichten mit einer Einbrennpaste beschichtet sind, wobei die beiden Außenelektroden jeweils mit den unbeschichteten Innenelektroden elektrisch verbunden sind. Das Vielschichtelement kann beispielsweise als Aktor oder Kondensator ausgestaltet sein.

Ausführungsbeispiele der Erfindung sind in den beigefügten schematischen Zeichnungen beispielhaft dargestellt. Es zeigen:
- Figur 1: eine perspektivische Seitenansicht eines Piezostapels mit den Seiten A, B, C und D entlang der Stapelrichtung,
- Figur 2: einen Piezostapel mit einer Schicht Funktionslack über der Seite A,

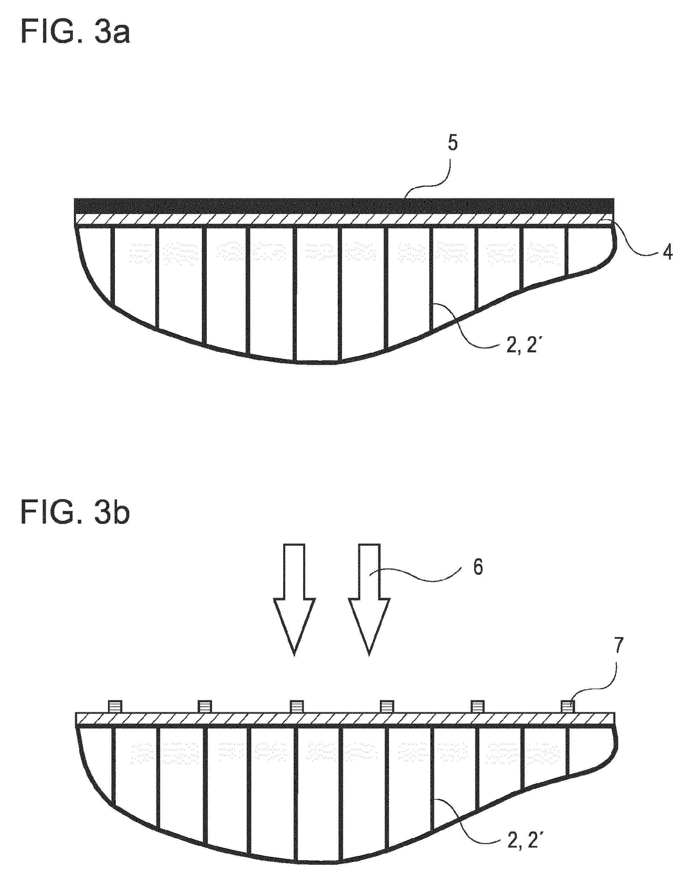

- Figur 3A: den Piezostapel aus Figur 2 im Querschnitt mit aufgelegter Elektrodenplatte,
- Figur 3B: eine zu Figur 3A alternative Ausführungsform mit auf eine Fotolackschicht elektrostatisch beschichtetem und aufgeschmolzenem Pulverlack und anschließender Belichtung,
- Figur 4: die nach einer der Ausführungsformen 3A oder 3B gehärtete Fotolackschicht bzw. Funktionslackschicht nach Entwicklung,
- Figur 5: den Piezostapel aus Figur 4 nach Aufbringen einer Einbrennpaste ohne Metallanteil nach Trocknen und Einbrennen,
- Figur 6: den Piezostapel aus Figur 5 nach Aufbringen einer Metallisierungspaste,
- Figur 7: einen vereinzelten, vollaktiven Piezostapel mit den Seiten A', B', C' und D' entlang der Stapelrichtung.

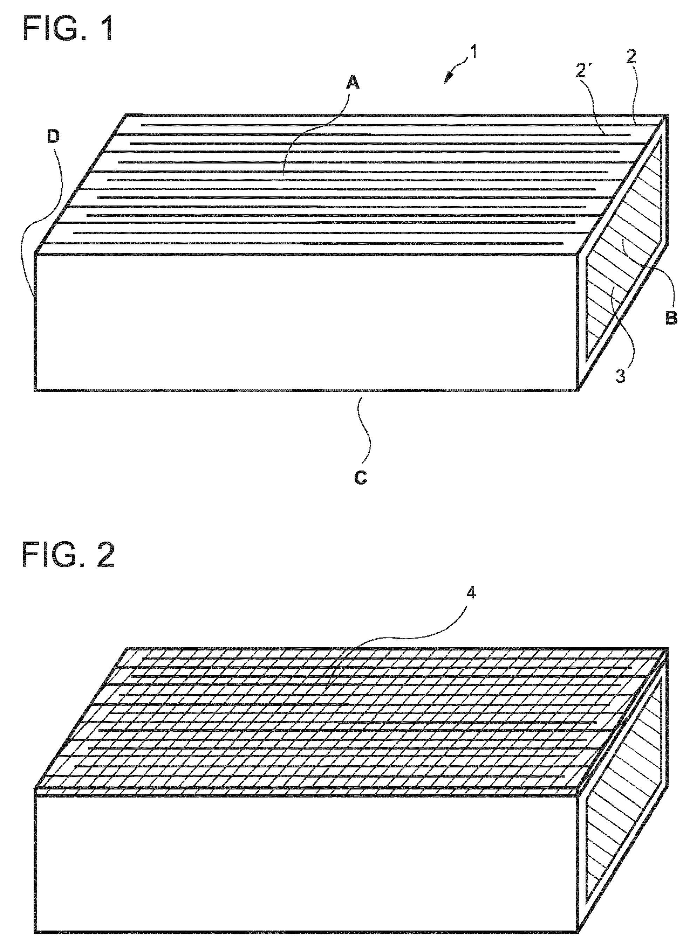

In einem Ausführungsbeispiel ist der Prozessablauf wie folgt:
a) Es wird ein gesinterter Piezostapel (1) mit den Seiten A, B, C und D entlang der Stapelrichtung bereitgestellt. Der Piezostapel besitzt (temporäre) Isozonen und Außenkontaktierungen (3), sodass über die Außenkontaktierung (3) jede zweite Innenelektrode (2) auf der Seite B sowie über die entsprechende Außenkontaktierung (3', nicht gezeigt) auf der Seite D jede zweite Innenelektrode (2') elektrisch angesteuert werden kann (vgl. Figur 1).
b) Der Piezostapel (1) wird auf der Seite A mit einer Schicht Funktionslack (4), in diesem Beispiel ein Negativlack, versehen (vgl. Figur 2). Beispielsweise wird ein PMMA-Dickschichtlack, typischerweise 50 µm, dessen Widerstand durch zusätzliche Komponenten in geeigneteter Weise eingestellt wurde, verwendet.
c) Es wird eine Elektrode (5) auf die Funktionslackschicht (4) aufgelegt. Dann wird eine gepulste Hochspannung an die Außenkontaktierung (3) auf der Seite B und die Elektrode (5) angelegt, sodass der Bereich über jeder zweiten Innenelektrode (2) durch den Wärmeeintrag gehärtet wird. Alternativ kann Pulverlack auf die eine Fotolackschicht über der elektrisch angesteuerten Innenelektrode (2) aufgebracht werden, indem die Pulverlackteilchen mit der entgegengesetzten Polarität aufgeladen werden. Der Pulverlack wird dann aufgeschmolzen und als Maske für die Belichtung (6) verwendet.

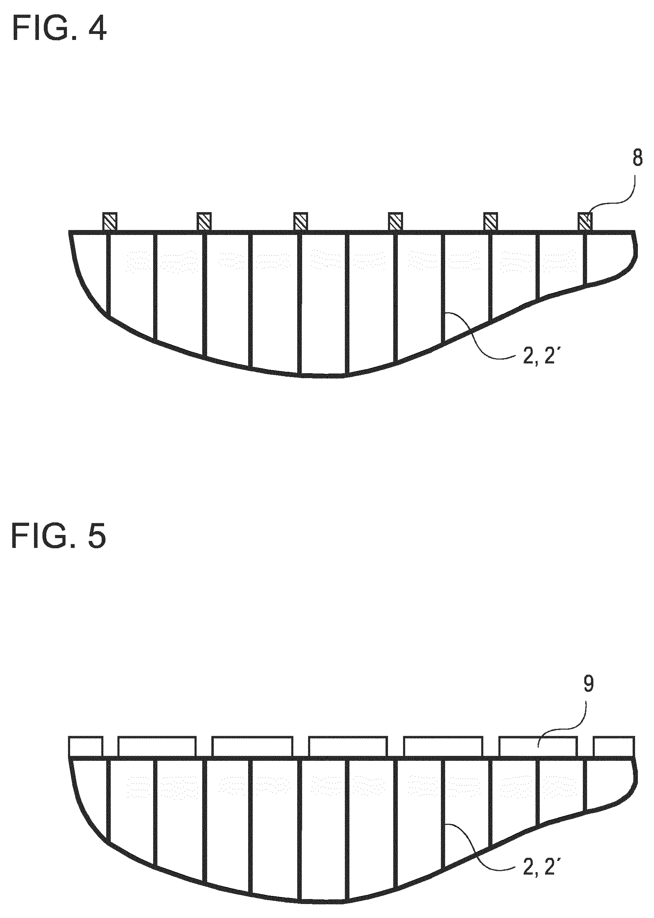

d) In Figur 4 ist der gehärtete Fotolack bzw. Funktionslack (8) nach Entwicklung, d. h. Herauslösen der nicht gehärteten bzw. polymerisierten Bestandteile zu sehen.
e) In Figur 5 wurde eine Einbrennpaste ohne Metallanteil (9) aufgebracht, entbindert und eingebrannt. Der restliche Pulverlack wurde beim Entbindern verbrannt und damit entfernt.

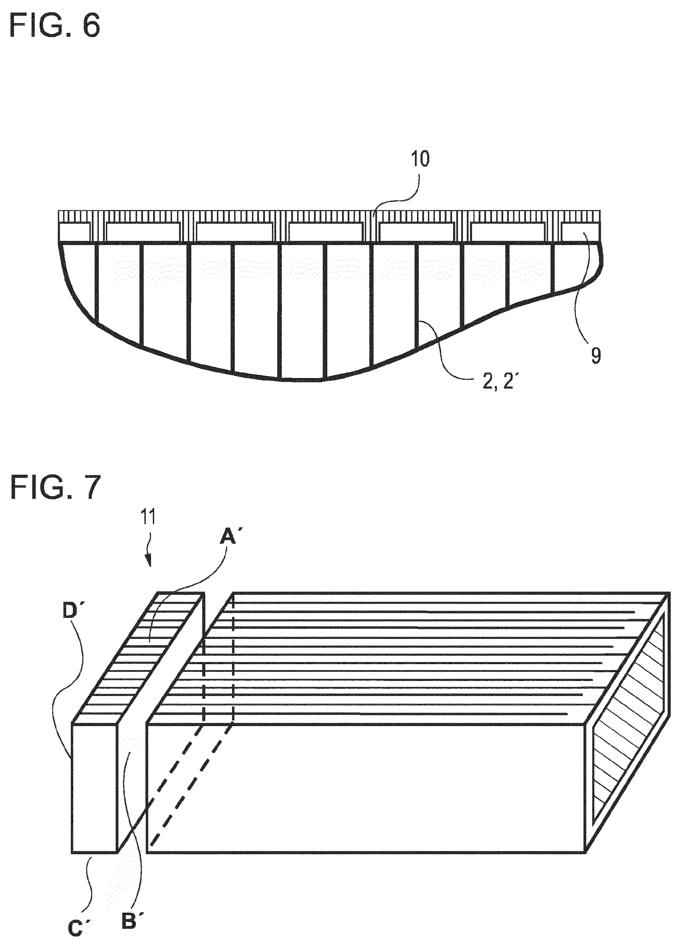

f) Figur 6 zeigt den Piezostapel aus Figur 5 nach dem Aufbringen, Trocknen und Einbrennen der Metallisierungspaste für die Außenkontakte.
g) In Figur 7 ist die Trennung des voll aktiven Piezostapels in Einzelaktoren mit den Seiten A', B', C' und D' gezeigt. Das Aufbringen der Metallisierungspaste (10), wie anhand von Figur 6 erläutert, kann vor oder nach der Trennung in Einzelaktoren (11) erfolgen.

### Bezugszeichenliste

- A, B, C, D: Seiten des Piezostapels in Stapelrichtung
- 1: Piezostapel
- 2, 2': Innenelektroden
- 3: Außenkontaktierung
- 4: ungehärtete Fotolackschicht
- 5: Gegenelektrode
- 6: Licht
- 7: elektrostatisch aufgebrachter und aufgeschmolzener Pulverlack
- 8: gehärteter Fotolack nach Entwicklung (d. h. Herauslösen oder Verbrennen der nichtgehärteten Bereiche)
- 9: Einbrennpaste ohne Metallanteil nach Aufbringen, Entbindern und Einbrennen
- 10: Metallisierungspaste nach Aufbringen, Trocknen und Einbrennen
- 11: Einzelaktor mit den Seiten A', B', C' und D'

## Patentansprüche

1. Verfahren zur Herstellung eines vollaktiven Stapels oder dessen grünem Vorläufer, umfassend:
- Bereitstellen eines gesinterten oder ungesinterten Stapels (1) mit den jeweils in Stapelrichtung verlaufenden Seiten A, B, C und D aus mehreren abwechselnd aufeinanderfolgenden keramischen dielektrischen Schichten und Innenelektrodenschichten (2, 2'), wobei die Innenelektrodenschichten (2, 2') bezüglich der Seiten A und C jeweils durchgehend ausgebildet sind und bezüglich entweder der Seite B oder der Seite D jeweils nicht durchgehend ausgebildet sind;
- Zusammenfassen und temporäres Kontaktieren der die jeweilige Seite kontaktierenden Innenelektroden (2, 2') oder deren ungesinterte Vorläufer auf einer der Seiten B oder D über einen Außenkontakt (3);
- Elektrisches Ansteuern der über die Seite B ansteuerbaren Innenelektroden und Beschichten mindestens der elektrisch angesteuerten Innenelektroden oder deren ungesinterte Vorläufer auf der Seite A mit Lack und Aushärten, Aufschmelzen und gegebenenfalls Entwickeln des Lacks;
- Elektrisches Ansteuern der über die Seite D ansteuerbaren Innenelektroden und Beschichten mindestens der elektrisch angesteuerten Innenelektroden oder deren ungesinterte Vorläufer auf der Seite C mit Lack und Aushärten, Aufschmelzen und gegebenenfalls Entwickeln des Lacks;
- Aufbringen einer Einbrennpaste auf die Seiten A und C, sowie Entbindern und Brennen der Einbrennpaste, wobei der Lack entfernt wird; und
- Vereinzeln des Stapels zu mindestens einem vollaktiven Stapel (11) mit den Seiten A', B', C' und D' oder dessen grünem Vorläufer mit den beschichteten Innenelektroden oder deren ungesinterte Vorläufer auf den Seiten A' und C' .

2. Verfahren nach Anspruch 1, wobei als Lack ein Fotolack und/oder ein Pulverlack und/oder ein Funktionslack verwendet werden.

3. Verfahren nach Anspruch 2, wobei der Funktionslack aus der Gruppe ausgewählt ist, die aus Lacken wie sie in der Elektronenstrahllithografie verwendet werden, Lacke mit durch Bestromung bewirkter thermischer Aushärtung, indirekt über Strom vernetzende Lacke und deren Mischungen besteht.

4. Verfahren nach Anspruch 3, wobei als indirekt über Strom vernetzender Lack die Kombination aus einem Fotolack und einem elektrolumineszierenden Lack verwendet wird.

5. Verfahren nach einem der Ansprüche 2 bis 4, wobei zum Aushärten des Funktionslacks eine Gegenelektrode auf die Seiten A und C gelegt wird und der Funktionslack durch den vom elektrischen Strom induzierten Wärmeeintrag beim Anlegen einer Spannung ausgehärtet und/oder vernetzt wird.

6. Verfahren nach einem der vorhergehenden Ansprüche, wobei zwischen Innenelektrodenschichten und Lack oder zwischen Lackoberfläche und Gegenelektrode ein Spalt vorgesehen wird.

7. Verfahren nach Anspruch 2, wobei der Pulverlack elektrostatisch auf die elektrisch angesteuerten Innenelektroden aufgetragen und aufgeschmolzen wird.

8. Verfahren nach Anspruch 7, wobei der Pulverlack auf eine Schicht aus Fotolack aufgetragen wird.

9. Verfahren nach einem der Ansprüche 2 oder 8, wobei der Fotolack durch Belichten ausgehärtet wird.

10. Verfahren nach einem der vorhergehenden Ansprüche, wobei die dielektrischen Schichten piezoelektrische Schichten sind.

11. Verfahren zur Herstellung eines vollaktiven Vielschichtelements umfassend:
- Herstellen eines vollaktiven Stapels (12) nach einem der Ansprüche 1 bis 10 und gegebenenfalls Sintern des vollaktiven Stapels oder dessen grünen Vorläufers;
- Aufbringen von Außenelektroden auf den Seiten A' und C' des vollaktiven Stapels (12) und Kontaktieren der unbeschichteten Innenelektroden, so dass die beiden Außenelektroden (11) mit den unbeschichteten Innenelektrodenschichten (2, 2') elektrisch verbunden sind.

## Claims

1. Method for producing a fully active stack or a green precursor thereof, comprising:
- provision of a sintered or unsintered stack (1) with the sides A, B, C and D respectively extending in the stack direction, made of a plurality of alternately successive ceramic dielectric layers and inner electrode layers (2, 2'), wherein the inner electrode layers (2, 2') are formed respectively continuously with respect to sides A and C and respectively not continuously with respect to either side B or side D;
- combination and temporary contacting of the inner electrodes (2, 2'), or the unsintered precursors thereof, contacting the respective side on one of sides B and D via an outer contact (3);
- electrical driving of the inner electrodes driveable via side B and coating of at least the electrically driven inner electrodes, or the unsintered precursors thereof, on side A with a coating material and curing, melting and optionally development of the coating material;
- electrical driving of the inner electrodes driveable via side D and coating of at least the electrically driven inner electrodes, or the unsintered precursors thereof, on side C with a coating material and curing, melting and optionally development of the coating material;
- application of a burn-in paste on sides A and C, and debinding and burning of the burn-in paste, the coating material being removed; and
- separation of the stack to form at least one fully active stack (11) with the sides A', B', C', and D' , or a green precursor thereof, with the coated inner electrodes, or the unsintered precursors thereof, on sides A' and C'.

2. Method according to Claim 1, wherein a photoresist and/or a powder coating material and/or a functional coating material is used as the coating material.

3. Method according to Claim 2, wherein the functional coating material is selected from the group which consists of coating materials as used in electron beam lithography, coating materials with thermal curing carried out by electric current application, coating materials crosslinking indirectly by means of current, and mixtures thereof.

4. Method according to Claim 3, wherein the combination of a photoresist and an electroluminescent coating material is used as a coating material crosslinking indirectly by means of current.

5. Method according to one of Claims 2 to 4, wherein, in order to cure the functional coating material, a mating electrode is placed on sides A and C, and the functional coating material is cured and/or crosslinked by electric current-induced input of heat when a voltage is applied.

6. Method according to one of the preceding claims, wherein a gap is provided between the inner electrode layers and the coating material or between the coating material surface and the mating electrode.

7. Method according to Claim 2, wherein the powder coating material is electrostatically applied onto the electrically driven inner electrodes and melted.

8. Method according to Claim 7, wherein the powder coating material is applied onto a layer of photoresist.

9. Method according to one of Claims 2 and 8, wherein the photoresist is cured by exposure to light.

10. Method according to one of the preceding claims, wherein the dielectric layers are piezoelectric layers.

11. Method for producing a fully active multilayer element, comprising:
- production of a fully active stack (12) according to one of Claims 1 to 10, and optionally sintering of the fully active stack or a green precursor thereof;
- application of outer electrodes onto sides A' and C' of the fully active stack (12) and contacting of the uncoated inner electrodes, so that the two outer electrodes (11) are electrically connected to the uncoated inner electrode layers (2, 2').

## Revendications

1. Procédé de fabrication d'un empilement pleinement actif ou de son précurseur vert, comprenant les étapes suivantes:
- préparer un empilement fritté ou non fritté (1) avec les côtés A, B, C et D s'étendant respectivement dans la direction d'empilement à partir de plusieurs couches diélectriques céramiques et de couches d'électrodes intérieures (2, 2') se succédant en alternance, dans lequel les couches d'électrodes intérieures (2, 2') sont respectivement formées de façon continue par rapport aux côtés A et C et ne sont respectivement pas formées de façon continue ni par rapport au côté B ni par rapport au côté D;
- réunir et mettre temporairement en contact les électrodes intérieures (2, 2') contactant le côté respectif ou leurs précurseurs non frittés sur un des côtés B ou D par un contact extérieur (3);
- exciter électriquement les électrodes intérieures pouvant être excitées par le côté B et recouvrir au moins les électrodes intérieures électriquement excitées ou leurs précurseurs non frittés sur le côté A avec une laque et durcir, faire fondre et éventuellement développer la laque;
- exciter électriquement les électrodes intérieures pouvant être excitées par le côté D et recouvrir au moins les électrodes intérieures électriquement excitées ou leurs précurseurs non frittés sur le côté C avec une laque et durcir, faire fondre et éventuellement développer la laque;
- appliquer une pâte à cuire sur les côtés A et C, ainsi que délianter et cuire la pâte à cuire, la laque étant ainsi éliminée; et
- diviser l'empilement en au moins un empilement pleinement actif (11) avec les côtés A', B', C' et D' ou son précurseur vert avec les électrodes intérieures recouvertes ou leurs précurseurs verts recouverts sur les côtés A' et C'.

2. Procédé selon la revendication 1, dans lequel on utilise comme laque une laque photosensible et/ou une laque en poudre et/ou une laque fonctionnelle.

3. Procédé selon la revendication 2, dans lequel la laque fonctionnelle est choisie dans le groupe, qui se compose de laques du type utilisé dans la lithographie à faisceau d'électrons, de laques avec durcissement thermique provoqué par un courant électrique, de laque se réticulant indirectement par un courant ou de leurs mélanges.

4. Procédé selon la revendication 3, dans lequel on utilise comme laque se réticulant indirectement par un courant la combinaison d'une laque photosensible et d'une laque électroluminescente.

5. Procédé selon l'une quelconque des revendications 2 à 4, dans lequel on dépose une contre-électrode sur les côtés A et C pour le durcissement de la laque fonctionnelle et on assure le durcissement et/ou la réticulation de la laque fonctionnelle par l'apport de chaleur induit par le courant électrique lors de l'application d'une tension.

6. Procédé selon l'une quelconque des revendications précédentes, dans lequel il est prévu une fente entre des couches d'électrodes intérieures et la laque ou entre la surface de la laque et la contre-électrode.

7. Procédé selon la revendication 2, dans lequel la laque en poudre est déposée par voie électrostatique sur les électrodes intérieures électriquement excitées et on la fait fondre.

8. Procédé selon la revendication 7, dans lequel on dépose la laque en poudre sur une couche de laque photosensible.

9. Procédé selon l'une des revendications 2 ou 8, dans lequel on durcit la laque photosensible par exposition à la lumière.

10. Procédé selon l'une quelconque des revendications précédentes, dans lequel les couches diélectriques sont des couches piézoélectriques.

11. Procédé de fabrication d'un composant multicouche pleinement actif, comprenant les étapes suivantes:
- fabriquer un empilement pleinement actif (12) selon l'une quelconque des revendications 1 à 10 et éventuellement fritter l'empilement pleinement actif ou son précurseur vert;
- appliquer des électrodes extérieures sur les côtés A' et C' de l'empilement pleinement actif (12) et mettre en contact les électrodes intérieures non recouvertes, de telle manière que les deux électrodes extérieures (11) soient électriquement reliées aux couches d'électrodes intérieures non recouvertes (2, 2').
